# EUROPÄISCHE PATENTSCHRIFT

(11) **EP 3 598 323 B1**
(45) Veröffentlichungstag und Bekanntmachung des Hinweises auf die Patenterteilung: **11.09.2024**
(21) Anmeldenummer: 18184682.5
(22) Anmeldetag: 20.07.2018
(51) Int. Cl.: G06F 30/15, G06F 30/20

(54) **TESTVERFAHREN ZUM TESTEN DER AUSWIRKUNGEN EINER TECHNISCHEN FUNKTION AUF EIN FAHRZEUG ODER EINE FAHRZEUGUMGEBUNG**
TEST METHOD FOR TESTING THE EFFECTS OF A TECHNICAL FUNCTION ON A VEHICLE OR A VEHICLE ENVIRONMENT
PROCÉDÉ D'ESSAI DESTINÉ AUX ESSAIS DES EFFETS D'UNE FONCTION TECHNIQUE SUR UN VÉHICULE OU SUR UN ENVIRONNEMENT DE VÉHICULE

(43) Veröffentlichungstag der Anmeldung: 22.01.2020
(73) Patentinhaber: VOLKSWAGEN AKTIENGESELLSCHAFT, 38440 Wolfsburg (DE)
(72) Erfinder: BÖRGER, Alexander, 38165 Flechtorf (DE); HOSSE, René Sebastian, 38120 Braunschweig (DE); VON DER DECKEN, Stefan, 38110 Braunschweig (DE); ZEISE, Ralf, 38444 Wolfsburg (DE)

(56) Entgegenhaltungen:
- DE-A1- 102015 224 558
- DE-A1- 102016 109 596
- US-A1- 2017 268 948
- SONILA DOBI ET AL: "Model-based Hazard and Impact Analysis", 9 December 2015 (2015-12-09), XP055542034, Retrieved from the Internet <URL:https://arxiv.org/ftp/arxiv/papers/1512/1512.02759.pdf> [retrieved on 20190116]

## Beschreibung

Die vorliegende Erfindung betrifft ein computerimplementiertes Verfahren zum Testen der Auswirkungen einer technischen Funktion auf ein Fahrzeug und/oder eine Fahrzeugumgebung. Ferner betrifft die Erfindung ein System zum Durchführen dieses Verfahrens mittels einer ersten und einer zweiten Recheneinheit.

Bei der Entwicklung neuer technischer Funktionen eines Fahrzeugs ist es wichtig, die von dieser Funktion ausgehenden Gefahren und Risiken zu testen, bevor die technische Funktion im Fahrzeug implementiert wird. Hierbei ist es wünschenswert, die technische Funktion so früh wie möglich testen zu können. Derzeit können Tests der technischen Funktion erst dann durchgeführt werden, wenn ein real entwickelter Softwarecode oder ein Prototyp für eine neue Hardware zur Verfügung steht.

DOBI, Sonila, et al. Model-based hazard and impact analysis. arXiv preprint arXiv:1512.02759, 2015, beschreibt eine modellgestützte Analyse zu Gefährdungen. Dabei wird insbesondere die Sicherheit beim Betrieb von Fahrzeugen untersucht. Es werden Gefährdungen als Verhaltenseigenschaften formalisiert und eine Gefährdungsanalyse auf der Grundlage von Zustandsautomaten, sowie eine Sicherheitsanalyse basierend auf einer Komponentenorientierten Modellierung beschrieben.

Die DE 10 2015 224 558 A1 betrifft ein Verfahren zum Evaluieren einer Fahrassistenzfunktion eines Kraftfahrzeugs, zum Betreiben eines automatisierten Fahrzeugobjekts mit einem Fahrzeugmodell und der Fahrassistenzfunktion in einer elektronischen Spielumgebung, wobei das automatisierte Fahrzeugobjekt in der Spielumgebung zusammen mit einem anderen Fahrzeugobjekt betrieben wird. Das andere Fahrzeugobjekt wird von einem Menschen gesteuert und die Fahrassistenzfunktion wird in Abhängigkeit vom Verhalten des automatisierten Fahrzeugobjekts in Reaktion auf das Verhalten des anderen Fahrzeugobjekts bewertet.

Die US 2017/268948 A1 beschreibt ein System zur Analyse der Energieeffizienz eines Fahrzeugs. Zusätzlich wird ein Kennwert für das Betriebsverhalten des Fahrzeugs ermittelt. Einzelne Eigenschaften von Fahrelementen oder Fahrzuständen, die für den Kennwert von besonderer Relevanz sind, werden identifiziert und diese Eigenschaften bei den jeweiligen Fahrelementen höher gewichtet. Ein charakteristischer Wert für das Betriebsverhalten des Fahrzeugs wird dabei als Ergebnis ausgegeben.

Unzutreffende Annahmen in einer zu Beginn der Entwicklung der technischen Funktion durchgeführten Gefährdungs- und Risikoanalyse führen zu einem späteren Entwicklungszeitpunkt zu erheblichen Nachbesserungskosten und Verzögerungen für die Implementierung der technischen Funktionen in dem Fahrzeug.

Der vorliegenden Erfindung liegt die Aufgabe zugrunde, ein computerimplementiertes Verfahren und ein System der eingangs genannten Art bereitzustellen, mit denen von der technischen Funktion ausgehende Gefahren frühzeitig erkannt werden können.

Erfindungsgemäß wird diese Aufgabe durch ein Verfahren mit den Merkmalen des Anspruchs 1 und ein System mit den Merkmalen des Anspruchs 11 gelöst. Vorteilhafte Ausgestaltungen und Weiterbildungen des Verfahrens und des Systems ergeben sich aus den abhängigen Ansprüchen.

Demgemäß wird bei dem computerimplementierten Verfahren zum Testen der Auswirkungen einer technischen Funktion auf ein Fahrzeug und/oder eine Fahrzeugumgebung die technische Funktion durch ein virtuelles Funktionsmodell beschrieben. Betriebszustände des Fahrzeugs werden durch ein virtuelles Fahrzeugmodell beschrieben. Bei dem Verfahren wird eine Simulation der Implementierung der technischen Funktion in dem Fahrzeug durchgeführt. Dabei wird das virtuelle Funktionsmodell mit dem virtuellen Fahrzeugmodell datentechnisch gekoppelt, es werden Steuerdaten für das virtuelle Fahrzeugmodell durch das virtuelle Funktionsmodell erzeugt, es werden technische Betriebszustände des Fahrzeugs mittels des virtuellen Fahrzeugmodells auf Basis der erzeugten Steuerdaten simuliert und es wird eine Gefahrenanalyse für zumindest einen der simulierten Betriebszustände des Fahrzeugs durchgeführt.

Das erfindungsgemäße Verfahren ermöglicht eine Vorhersage des Verhaltens des Fahrzeugs für eine Implementierung der technischen Funktion, deren Auswirkungen getestet werden. Durch die Gefahrenanalyse können auf diese Weise etwaige von der Implementierung der technischen Funktion ausgehende Gefahren frühzeitig erkannt werden. Insbesondere können diese Gefahren erkannt werden, bevor eine Umsetzung der technischen Funktion in einem Hardwarebauteil oder als Software zur Verfügung steht und in einem realen Fahrzeug implementiert werden kann. Es können dabei technische Betriebszustände des Fahrzeugs erzeugt werden, die sich aus den Steuerdaten ergeben, welche aus der technischen Funktion resultieren, indem das virtuelle Funktionsmodell der technischen Funktion diese Steuerdaten erzeugt und in das virtuelle Fahrzeugmodell einspeist.

Durch die Gefahrenanalyse soll insbesondere sichergestellt werden, dass die Norm ISO 26262 für funktionale Sicherheit sowie die Norm ISO PAS 21448 (Safety of the Intended Functionality) von einem Fahrzeug erfüllt ist, in welchem die technische Funktion implementiert ist.

Die Komplexität eines modernen Fahrzeugs bedingt es, dass es nicht ohne Weiteres möglich ist, alle Auswirkungen einer technischen Funktion auf das Fahrzeug bzw. auf die Fahrzeugumgebung ohne umfassende Tests zu erkennen. Durch das erfindungsgemäße Verfahren können diese Tests bereits zu einem Zeitpunkt durchgeführt werden, zu dem nur ein virtuelles Funktionsmodell für die technische Funktion vorliegt. Ein solches virtuelles Funktionsmodell kann vielfach aus den Randbedingungen und technischen Anforderungen sehr frühzeitig in der Entwicklung der technischen Funktion erstellt werden, so dass das erfindungsgemäße Verfahren zu einem sehr frühen Zeitpunkt bei der Entwicklung der technischen Funktion ausgeführt werden kann. Etwaige von der technischen Funktion ausgehende Gefahren können auf diese Weise frühzeitig erkannt werden.

Unter einem virtuellen Funktionsmodell wird in dieser Schrift die atomare Einheit eines virtuellen funktionalen Testens verstanden. Das virtuelle Funktionsmodell stellt ein auf geforderten Eigenschaften basierendes Modell einer Funktionseinheit dar. Im Gegensatz zu einem physischen Modell gibt es bei dem virtuellen Funktionsmodell jedoch kein reales Objekt, sondern nur die Beschreibung einiger funktionaler Eigenschaften. Das virtuelle Funktionsmodell weist Eingangsgrößen, Ausgangsgrößen und die zwischen ihnen vermittelnden Funktionen auf. Unter dem virtuellen funktionalen Testen wird dabei ein Test verstanden, bei dem das virtuelle Funktionsmodell einer technischen Funktion in einer Simulation getestet wird. Bei der Simulation wird ein reales System, das sehr komplex, groß, unhandlich oder auch nicht vorhanden ist, durch ein Modell ersetzt, das sich im Kontext einer Fragestellung genau wie das reale System verhält. Bei dem Testen handelt es sich um einen Prozess, der aus Aktivitäten des Lebenszyklus einer technischen Einheit, welche die technische Funktion bereitstellt, besteht. Ziel des Prozesses ist es, sicherzustellen, dass die Aktivitäten allen festgelegten Anforderungen genügen, dass sie ihren Zweck erfüllen, und etwaige Fehlerzustände und/oder Gefahren zu finden.

Das Funktionsmodell oder das Fahrzeugmodell ist in dem Sinne virtuell, als dass eine Eigenschaft nicht in einer physischen Form existiert, aber in ihrem Wesen bzw. ihrer Wirkung einem in dieser Form existierenden Objekt gleicht.

Unter einem Modell wird in dieser Schrift eine vereinfachte, anschauliche Abbildung eines Objekts verstanden. Das Modell muss dabei nicht die ganze Wirklichkeit erfassen. Es verhält sich jedoch in einem konkreten Zusammenhang in gleicher Weise wie das reale Objekt selbst.

Erfindungsgemäß werden für das virtuelle Fahrzeugmodell kritische Betriebszustände definiert und gespeichert. Nach dem Simulieren der technischen Betriebszustände des Fahrzeugs wird dann geprüft, ob diese technischen Betriebszustände mit einem der gespeicherten kritischen Betriebszustände übereinstimmt, und, falls eine Übereinstimmung festgestellt wird, wird bei der Gefahrenanalyse eine Gefahrzustand festgestellt und der Gefahrzustand ausgegeben. Hierdurch kann vorteilhafterweise geprüft werden, ob bestimmte im Voraus bekannte kritische Betriebszustände bei der Implementierung der technischen Funktion auftreten werden.

Gemäß einer Ausgestaltung des erfindungsgemäßen Verfahrens setzt das virtuelle Funktionsmodell ein technisches System voraus. Ferner gibt es die Art der technischen Funktion an und schließlich umfasst es einen Wichtigkeitsoperator zwischen dem vorausgesetzten technischen System und der Art der technischen Funktion. Das technische System ist dabei eine Einheit, auf welche sich die technische Funktion bezieht. Es kann jedoch auch die Bezeichnung einer Funktion sein oder die einer Komponente seiner Umgebung. Die Art der technischen Funktion kann eine selbsttätige Systemaktivität, eine Benutzerinteraktion oder eine Schnittstellenanforderung umfassen. Bei der selbsttätigen Systemaktivität startet eine Funktion automatisch und führt sie anschließend automatisch aus. Bei einer Benutzerinteraktion stellt das System seinem Benutzer eine Funktionalität zur Verfügung oder es tritt mit ihm in Interaktion. Bei einer Schnittstellenanforderung kann das System eine Funktion nur in Abhängigkeit von einer Informationsübergabe durch einen Dritten, der nicht Benutzer ist, ausführen. Beispielsweise können Informationen aus der Umgebung des virtuell abgebildeten Fahrzeugs übergeben werden. Der Wichtigkeitsoperator stellt eine Verbindung zwischen dem vorausgesetzten technischen System und der Art der technischen Funktion her. Der Wichtigkeitsoperator kann angeben, dass ein Betriebszustand nicht auftreten darf, dass ein Betriebszustand auftreten muss, dass ein Betriebszustand auftreten sollte oder dass ein Betriebszustand auftreten wird. Der Wichtigkeitsoperator ist insbesondere wichtig für die Gefahrenanalyse. In Verbindung mit dem Wichtigkeitsoperator kann ferner ein Prozesswort verwendet werden. Der Wichtigkeitsoperator und das Prozesswort geben dann die Funktion des Systems an.

Bei dieser Art eines virtuellen Funktionsmodells ist es möglich, Anforderungssätze für die technische Funktion, deren Auswirkungen getestet werden sollen, zu formulieren. Derartige Anforderungssätze können beispielsweise wie folgt formuliert werden: "Das Fahrzeug muss dem Fahrer die aktuelle Geschwindigkeit anzeigen"; "Falls das Fahrzeug feststellt, dass es auf ein Hindernis aufprallt, muss das Fahrzeug den Front-Airbag aktivieren"; "Falls das Fahrzeug feststellt, dass nicht alle Türen geschlossen sind, darf das Fahrzeug nicht losfahren"; "Das Fahrzeug sollte dem Fahrer die Möglichkeit bieten, die hinteren Türen zu verriegeln".

Diese Anforderungssätze werden gemäß einer Ausgestaltung der vorliegenden Erfindung automatisch in ein virtuelles Funktionsmodell der technischen Funktion überführt. Zum Testen der technischen Funktion ist es daher nicht erforderlich, dass bereits ein Softwarecode oder eine Hardware für die technische Funktion zur Verfügung steht. Bereits bei der Definition der technischen Funktionalität können die Anforderungssätze formuliert werden, in ein virtuelles Funktionsmodell überführt werden und anschließend die Auswirkungen der technischen Funktion mittels dieses virtuellen Funktionsmodells simuliert und getestet werden.

Gemäß einer Weiterbildung des erfindungsgemäßen Verfahrens erfolgt die datentechnische Kopplung des virtuellen Funktionsmodells mit dem virtuellen Fahrzeugmodell durch eine Transformation des virtuellen Funktionsmodells und des virtuellen Fahrzeugmodells in einen endlichen Zustandsautomaten. In dem Zustandsautomaten können die Auswirkungen von Zuständen des virtuellen Funktionsmodells auf das virtuelle Fahrzeugmodell getestet und überprüft werden.

Gemäß einer Weiterbildung des erfindungsgemäßen Verfahrens wird zusätzlich die Fahrzeugumgebung berücksichtigt. Diese wird insbesondere durch ein virtuelles Umgebungsmodell beschrieben. Das virtuelle Umgebungsmodell wird datentechnisch mit dem virtuellen Fahrzeugmodell und/oder dem virtuellen Fahrzeugmodell gekoppelt. Die technischen Betriebszuständen des Fahrzeugs werden dann mittels des virtuellen Fahrzeugmodells und des virtuelles Umgebungsmodell auf Basis der erzeugten Steuerdaten simuliert. Auf diese Weise kann der Einfluss der jeweiligen Zustände des Modells auf ein anderes Modell getestet werden. Beispielsweise kann das virtuelle Umgebungsmodell verschiedene technische Parameter umfassen, wie Witterungsverhältnisse, Verkehrsinformationen sowie die Positionen und Bewegungen anderer Verkehrsteilnehmer.

Gemäß einer Weiterbildung des erfindungsgemäßen Verfahrens werden bei der Gefahrenanalyse Gefährdungen durch simulierte technische Betriebszustände des Fahrzeugs berücksichtigt. Beispielsweise können gefährdende Betriebszustände vorab gespeichert werden. Es kann bei der Gefahrenanalyse dann geprüft werden, ob diese gefährdenden Betriebszustände auftreten, wenn bei der Simulation die technische Funktion auf ein Fahrzeug oder eine Fahrzeugumgebung wirkt. Auf diese Weise kann frühzeitig geprüft werden, ob vorher bekannte Gefährdungen durch die Implementierung der zu entwickelnden technischen Funktion auftreten können.

Des Weiteren kann bei der Gefahrenanalyse die Beherrschbarkeit einer Gefährdung durch einen Fahrer des Fahrzeugs oder durch andere am Straßenverkehr beteiligte Verkehrsteilnehmer berücksichtigt werden. Auch in diesem Fall kann für im Voraus bekannte Gefährdungen angegeben werden, ob und inwiefern sie durch einen Fahrer oder andere Verkehrsteilnehmer beherrschbar sind. Diese vorab erfassten Daten können in die Gefahrenanalyse einfließen, wenn sich bei dem Verfahren ergibt, dass bei der Implementierung der technischen Funktion in dem Fahrzeug eine entsprechende Gefährdung auftreten kann.

Des Weiteren können bei der Gefahrenanalyse oder der Definition kritischer Betriebszustände gespeicherte Daten berücksichtigt werden, welche die Umwelt und das Fahrverhalten des durch das virtuelle Fahrzeugmodell beschriebene Fahrzeug und/oder welche technische Betriebszustände bei Unfällen von Fahrzeugen beschreiben. Auch auf diese Weise können die Auswirkungen einer technischen Funktion auf das Fahrzeug und eine dabei möglicherweise auftretende Gefahr besser analysiert und eingeschätzt werden.

Gemäß einer weiteren Ausgestaltung des erfindungsgemäßen Verfahrens setzt das virtuelle Fahrzeugmodell bei der Simulation die erzeugten Steuerdaten in virtuelle fahrzeuginterne Signale um. Die virtuellen fahrzeuginternen Signale können beispielsweise eine Bewegung des Fahrzeugs beschreiben. Ferner können diese virtuellen fahrzeuginternen Signale virtuelle Sensoren des Fahrzeugs und/oder einen virtuellen Antrieb des Fahrzeugs steuern. Auf diese Weise ergibt sich eine realitätsnahe Simulation der Auswirkungen der technischen Funktion auf das Fahrzeug und auf die Umgebung des Fahrzeugs. Etwaige Gefährdungen können auf diese Weise besonders gut erfasst werden.

Des Weiteren betrifft die Erfindung ein System zum Testen der Auswirkungen einer technischen Funktion auf ein Fahrzeug und/oder eine Fahrzeugumgebung. Das System umfasst eine erste Recheneinheit, die ausgelegt ist, die technische Funktion durch ein virtuelles Funktionsmodell zu beschreiben, eine zweite Recheneinheit, die ausgelegt ist, Betriebszustände des Fahrzeugs durch ein virtuelles Fahrzeugmodell zu beschreiben, und die datentechnisch mit der ersten Recheneinheit gekoppelt ist. Ferner umfasst das System eine Simulationseinheit, die ausgelegt ist, eine Simulation der Implementierung der technischen Funktion in dem Fahrzeug durchzuführen, indem folgende Schritte durchgeführt werden: Erzeugen von Steuerdaten für das virtuelle Fahrzeugmodell der zweiten Recheneinheit durch das virtuelle Funktionsmodell der ersten Recheneinheit, Simulieren von technischen Betriebszuständen des Fahrzeugs mittels des virtuellen Fahrzeugmodells der zweiten Recheneinheit auf Basis der erzeugten Steuerdaten; Durchführen einer Gefahrenanalyse für zumindest einen der simulierten Betriebszustände des Fahrzeugs; Definieren und Speichern von kritischen Betriebszuständen für das virtuelle Fahrzeugmodell; Prüfen, ob diese technischen Betriebszustände mit einem der gespeicherten kritischen Betriebszuständen übereinstimmt, und, falls eine Übereinstimmung festgestellt wird, bei der Gefahrenanalyse ein Gefahrzustand festgestellt wird und der Gefahrzustand ausgegeben wird.

Das System ist ausgebildet, dass erfindungsgemäße Verfahren durchzuführen. Es weist daher dieselben Vorteile auf.

Die Simulationseinheit des Systems umfasst insbesondere einen Speicher, in welchem vorab definierte kritische Betriebszustände für das virtuelle Fahrzeugmodell gespeichert sind. Die Simulationseinheit ist dann ausgebildet, nach dem Simulieren der technischen Betriebszustände des Fahrzeugs zu prüfen, ob diese technischen Betriebszustände mit einem der gespeicherten kritischen Betriebszustände übereinstimmt, und, falls eine Übereinstimmung festgestellt wird, bei der Gefahrenanalyse eine Gefahrzustand festzustellen.

Schließlich betrifft die Erfindung ein Computerprogrammprodukt, umfassend Befehle, die bei der Ausführung durch zumindest einen Computer diesen veranlassen, das vorstehend beschriebene Verfahren auszuführen.

Im Folgenden wird ein Ausführungsbeispiel des erfindungsgemäßen Verfahrens anhand der angefügten Zeichnungen erläutert.

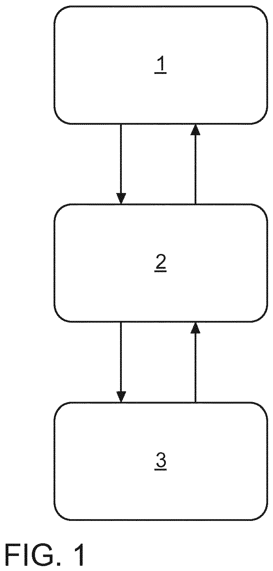

- Figur 1: zeigt den Aufbau einer Vorrichtung zur Durchführung des erfindungsgemäßen Verfahrens,
- Figur 2: veranschaulicht ein Ausführungsbeispiel des erfindungsgemäßen Verfahrens und
- Figur 3: gibt eine weitere Veranschaulichung eines Ausführungsbeispiels des erfindungsgemäßen Verfahrens.

Bei dem Ausführungsbeispiel des erfindungsgemäßen Verfahrens sollen die Auswirkungen einer definierten technischen Funktion auf ein Fahrzeug und/oder auf eine Fahrzeugumgebung getestet werden. Es soll somit nicht die technische Funktion selbst getestet werden, sondern die Auswirkungen der technischen Funktion auf ein Fahrzeug bzw. eine Fahrzeugumgebung. Durch das Testen sollen insbesondere Gefahren für Insassen des Fahrzeugs oder andere Verkehrsteilnehmer erkannt und fahrererlebbare Risiken durch unerwünschtes oder fehlerhaftes Verhalten von Komponenten des Fahrzeugs, die von der technischen Funktion beeinflusst sind, überprüft werden.

Bei dem Verfahren wird zunächst die technische Funktion durch ein virtuelles Funktionsmodell 1 beschrieben. Das virtuelle Funktionsmodell 1 wird auf Basis einer Funktionsbeschreibung der technischen Funktion und des funktionalen Sicherheitskonzepts erstellt. Dies sind die Eingangsgrößen für das Funktionsmodell 1. Die Eingangsgrößen führen zu Anforderungen an das Funktionsmodell 1. Bei dem Ausführungsbeispiel können die Anforderungen in normaler Sprache als Anforderungssatz beschrieben werden. Die funktionellen Anforderungen werden somit in formalisierter natürlicher Sprache erfasst. Diese wird dann automatisiert in das virtuelle Funktionsmodell 1 konvertiert. In der Anforderung wird das betrachtete technische System eindeutig benannt. Es kann die Bezeichnung der Funktion sein, aber auch die einer Komponente seiner Umgebung.

Des Weiteren umfasst das Funktionsmodell die Art der Funktionalität. Beispielsweise wird angegeben, ob es sich um eine selbsttätige Systemaktivität, eine Benutzerinteraktion oder eine Schnittstellenanforderung handelt. Das betrachtete technische System und die Art der Funktionalität werden über einen Wichtigkeitsoperator gekoppelt. Wichtigkeitsoperatoren sind beispielsweise DARF...NICHT, MUSS, SOLLTE und WIRD. Ein Anforderungssatz endet schließlich mit einem Prozesswort. Ein Anforderungssatz kann somit für ein gegebenes System, einen Wichtigkeitsoperator, ein Prozesswort, einer Funktionalität, ein Objekt und eine Bedingung umfassen. Ein Beispiel für einen solchen Anforderungssatz ist: "Falls das Fahrzeug feststellt, dass es auf ein Hindernis aufprallt, muss das Fahrzeug den Front-Airbag aktivieren."

Die Funktionsbeschreibung anhand von Anforderungssätzen wird bei dem Verfahren automatisch durch eine Software in ein virtuelles Funktionsmodell überführt. Die in den Anforderungssätzen beschriebenen Eingangsgrößen werden als Signale in diesem Funktionsmodell verankert. Dabei wird davon ausgegangen, dass die in Testfällen beschriebenen Szenarien bei ihrer Ausführung fahrererlebbare Datensätze liefern. Die technische Funktion selbst kann in ein simuliertes Fahrzeug eingebettet werden oder das simulierte Fahrzeug selbst, gegebenenfalls in veränderter Form, sein. Falls die technische Funktion das Fahrzeug selbst betrifft, wird eine Ebene geschaffen, der die von einer Simulation gelieferten Daten in fahrzeuginterne Signale umsetzt und die Aktionen der technischen Funktion für die Simulation als Bewegung des Fahrzeugs sichtbar werden lässt. Alternativ oder zusätzlich werden Sensoren des Fahrzeugs oder der Antrieb des Fahrzeugs simuliert. Das virtuelle Funktionsmodell 1 ist dann datentechnisch in ein virtuelles Fahrzeugmodell 2 eingebettet. Falls die technische Funktion nicht das Fahrzeug selbst ist, wird eine Schnittstelle zur Kopplung des virtuellen Funktionsmodells 1 für die technische Funktion durch ein virtuelles Fahrzeugmodell 2 realisiert.

Die Betriebszustände des Fahrzeug werden durch das virtuelle Fahrzeugmodell 2 beschrieben. Das virtuelle Fahrzeugmodell 2 umfasst die grundlegenden Aspekte der Fahrdynamik. Außerdem dient das virtuelle Fahrzeugmodell 2 als Schnittstelle zwischen einer simulierten Umwelt und dem virtuellen Funktionsmodell 1. Es simuliert alle Sensoren und Aktoren des Fahrzeugs und stellt die entsprechenden Daten zur Verfügung.

Für das virtuelle Fahrzeugmodell 2 werden außerdem kritische Betriebszustände definiert. Solche kritischen Betriebszustände sind insbesondere sicherheitsrelevant, d. h. es ist im Hinblick auf die Sicherheit eines Fahrzeugs, in welchem eine bestimmte technische Funktion implementiert ist, wichtig zu wissen, ob bei der Implementierung dieser technischen Funktion solche kritischen Betriebszustände auftreten können.

Des Weiteren wird die Fahrzeugumgebung durch ein virtuelles Umgebungsmodell 3 beschrieben. Dieses virtuelle Umgebungsmodell 3 umfasst unter anderem eine Straßentopologie sowie die Beschaffenheit und den Zustand der Straßen, eine Leitinfrastruktur, zu der Begrenzungen, Markierungen und Verkehrszeichen gehören, temporäre Überlagerungen der Straßentopologie und Leitinfrastruktur, bewegliche Objekte und Verkehrsteilnehmer sowie schließlich die Umweltbedingungen und deren Auswirkungen auf die anderen Parameter.

Das virtuelle Funktionsmodell 1, das virtuelle Fahrzeugmodell 2 und das virtuelle Umgebungsmodell 3 werden durch Recheneinheiten realisiert, die ausgebildet sind, diese Modelle 1, 2 und 3 zu erzeugen. Die Modelle 1, 2 und 3 werden datentechnisch miteinander gekoppelt, wodurch eine Transformation in einen endlichen Zustandsautomaten 4 erfolgt. Anhand dieses endlichen Zustandsautomaten 4 können die Auswirkungen der technischen Funktion auf das Fahrzeug bzw. die Fahrzeugumgebung getestet werden.

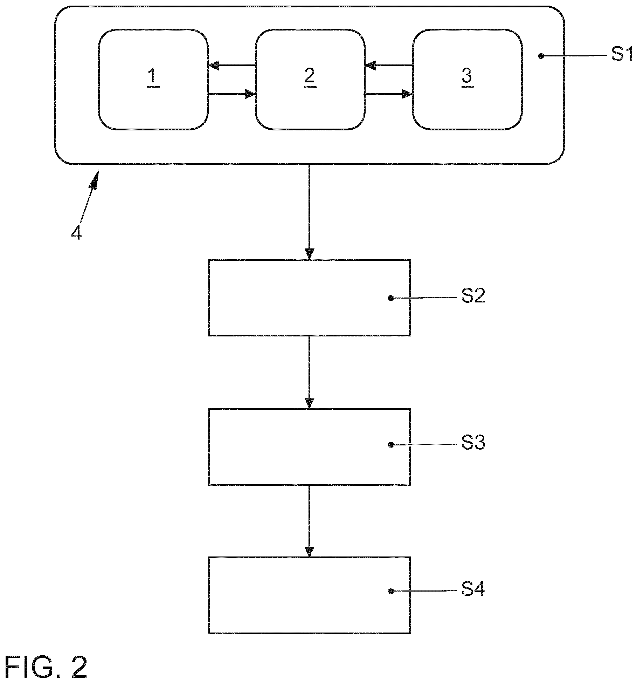

Der Test wird durch ein computerimplementiertes Verfahren durchgeführt, bei dem eine Simulation der Implementierung der technischen Funktion in dem Fahrzeug durch eine Simulationseinheit durchgeführt wird. Die Simulationseinheit umfasst einen Speicher, in welchem die vorab definierten kritische Betriebszustände für das virtuelle Fahrzeugmodell 2 gespeichert sind. Die Simulation wird im Folgenden anhand der Figur 2 beschrieben:
In einem Schritt S1 wird das virtuelle Funktionsmodell 1 mit dem virtuellen Fahrzeugmodell 2 und optional auch mit dem virtuellen Umgebungsmodell 3 zu einem endlichen Zustandsautomaten 4 datentechnisch gekoppelt, wie es vorstehend beschrieben wurde.

In einem Schritt S2 werden Steuerdaten für das virtuelle Fahrzeugmodell 2 durch das virtuelle Funktionsmodell 1 erzeugt. Diese Steuerdaten sind Eingangsgrößen für das virtuelle Fahrzeugmodell 2, so dass die Funktionen und Auswirkungen solcher Steuerdaten auf das Fahrzeug simuliert werden können.

In dem Schritt S3 werden die technischen Betriebszustände des Fahrzeugs mittels des virtuellen Fahrzeugmodells 2 auf Basis der erzeugten Steuerdaten simuliert.

Im Schritt S4 wird schließlich eine Gefahrenanalyse für zumindest einen der simulierten Betriebszustände des Fahrzeugs durchgeführt. Anhand dieser Gefahrenanalyse können Risiken, die durch die getesteten Auswirkungen der technischen Funktion bedingt sind, erkannt werden.

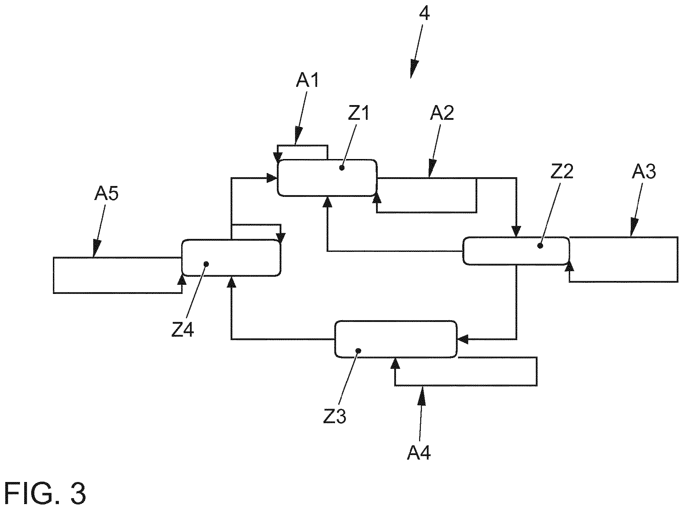

Mit Bezug zu Figur 3 wird ein konkretes Beispiel für einen Test der Auswirkungen einer technischen Funktion auf ein Fahrzeug bzw. die Fahrzeugumgebung beschrieben:
Die technische Funktion ist das automatisierte Laden eines elektrisch angetriebenen Fahrzeugs an einer standardisierten automatischen Ladestation im öffentlichen Raum durch einen Ladesäulenassistent.

Bei dem Verfahren wird somit die technische Funktion der Realisierung eines automatischen Ladens für ein Elektrofahrzeug, ein so genannter automatisierter Ladesäulenassistent oder Ladeassistent, betrachtet. Für diese technische Funktion wird ein virtuelles Funktionsmodell 1 definiert. Dieses Funktionsmodell 1 wird auf Basis der folgenden funktionalen Anforderungen geschaffen:
- Falls sich der Ladeassistent im Zustand <AUS> befindet, und das Kommando zum Laden erkennt, soll es in den Zustand <VORBEREITEN> wechseln.
- Falls der Ladeassistent im Zustand <VORBEREITEN> feststellt, dass das Fahrzeug nicht steht, soll es abwarten.
- Falls der Ladeassistent im Zustand <VORBEREITEN> feststellt, dass das Fahrzeug steht, soll es sich bei der Ladestation anmelden.
- Falls der Ladeassistent im Zustand <VORBEREITEN> feststellt, dass es bei der Ladestation angemeldet ist, soll es in den Zustand <LADEN> wechseln.
- Im Zustand <LADEN> soll der Ladeassistent die Kommunikation zwischen Batteriemanagement und Ladesäule initialisieren und verfolgen.
- Falls der Ladeassistent im Zustand <LADEN> feststellt, dass das Laden beendet ist, soll es in den Zustand <ABSCHLUSS> wechseln.
- Im Zustand <ABSCHLUSS> soll sich der Ladeassistent bei der Ladesäule abmelden und in den Zustand <AUS> wechseln.
- Bevor das Fahrzeug losfährt, muss das Motorsteuergerät eine Freigabe des Ladeassistenten einholen.

Das virtuelle Funktionsmodell 1 simuliert dabei den Ladeassistent und die Wechselwirkung desselben mit einem zu ladenden Fahrzeug.

Dieses virtuelle Funktionsmodell 1 wird datentechnisch mit einem virtuellen Fahrzeugmodell 2 gekoppelt und auf diese Weise ein endlicher Zustandsautomat 4 geschaffen. Ferner werden Einflüsse der Fahrzeugumgebung durch ein virtuelles Umgebungsmodell 3 berücksichtigt. Das virtuelle Umgebungsmodell 3 berücksichtigt unter anderem die Topologie der Straßen.

Für das virtuelle Fahrzeugmodell 2 sind in dem Speicher der Simulationseinheit vorab definierte kritische Betriebszustände gespeichert. Beispielsweise kann gespeichert sein, dass ein kritischer Betriebszustand vorliegt, wenn das Fahrzeug mit einem Ladearm des Ladesäulenassistenten gekoppelt ist, die Feststellbremse gelöst ist und das Fahrzeug auf einer geneigten Fahrbahn abgestellt ist. Beispielsweise kann auch gespeichert sein, dass ein kritischer Betriebszustand vorliegt, wenn der Ladeassistent im Zustand <Laden> ist, also in einem Zustand, in dem das Fahrzeug mit einem Ladearm eines Ladesäulenassistenten gekoppelt ist, und gleichzeitig das Fahrzeug im Zustand <in Bewegung> ist. Das Fahrzeug kann beispielsweise dann in den Zustand <in Bewegung> wechseln, wenn das virtuelle Funktionsmodell zumindest eine Bedingung vorsieht, deren Eintreten zu einer Bewegung der Räder führt, und diese Bedingung auch eintritt. Beispielsweise kann die Bedingung sein, dass die Feststellbremse gelöst wird und sich das Fahrzeug zu diesem Zeitpunkt auf einer geneigten Fläche befindet. Wenn diese Bedingung eintritt, dann wechselt das Fahrzeug im virtuellen Fahrzeugmodell 2 in den Zustand <in Bewegung>. Die Zustandskombination Ladeassistent im Zustand <Laden> und Fahrzeug im Zustand <in Bewegung> ist also ein Beispiel eines vorab definierten kritischen Betriebszustandes.

Der Zustandsautomat 4 ist in Figur 3 gezeigt. Er kann auf einem computerlesbaren Speichermedium implementiert sein, auf dem Befehle gespeichert sind, die bei der Ausführung durch einen Computer diesen veranlassen, das erfindungsgemäße Verfahren auszuführen.

Die Funktionsweise des Zustandsautomaten 4 wird im Folgenden beschrieben:
Der Zustandsautomat 4 startet im Zustand Z1. In diesem Fall befindet sich der Ladeassistent im Zustand <AUS>. Erfolgt in diesem Zustand Z1 eine Anfrage A1 für eine Fahrfreigabe, wird ein positives Signal erzeugt. Wird in einer Anfrage A2 ein Laden des Fahrzeugs angefordert, prüft der Zustandsautomat 4, ob das von dem virtuellen Fahrzeugmodell 2 repräsentierte Fahrzeug steht. Ist dies nicht der Fall, verbleibt der Zustandsautomat 4 im Zustand Z1. Ist dies der Fall, geht der Zustandsautomat 4 in den Zustand Z2 über.

Im Zustand Z2 ist der Zustand des Ladeassistent <VORBEREITEN>. Von dem virtuellen Funktionsmodell 1 werden Steuerdaten für das virtuelle Fahrzeugmodell 2 erzeugt, so dass dieses ein Anmelden an der Ladesäule initiiert. Erfolgt in dem Zustand Z2 eine Anfrage A3 für eine Fahrfreigabe, wird diese abgelehnt. Wenn die Anmeldung an der Ladesäule fehlgeschlagen ist, wird die Anmeldung beendet und der Zustandsautomat 4 geht in Zustand Z1 über. Wenn die Anmeldung erfolgreich beendet wurde, geht der Zustandsautomat 4 in den Zustand Z3 über.

Im Zustand Z3 wird das Fahrzeug des virtuellen Fahrzeugmodells 2 geladen. Ein entsprechendes Signal wird an das Batteriemanagementsystem des Fahrzeugs des virtuellen Fahrzeugmodells 2 gesendet. Dieses wartet auf das Ladeende. Wenn in diesem Zustand Z3 eine Anfrage A4 für eine Fahrfreigabe gestellt wird, wird diese abgelehnt. Wenn das Laden beendet wurde, geht der Zustandsautomat 4 in den Zustand Z4 über. Der Ladeassistent befindet sich dann im Zustand <ABSCHLUSS>. Das Fahrzeug des virtuellen Fahrzeugmodells 2 meldet sich von der Ladesäule ab. Wenn in diesem Zustand Z4 eine Anfrage A5 für eine Fahrfreigabe gestellt wird, wird diese abgelehnt. Wenn die Abmeldung von der Ladesäule nicht von der Ladesäule bestätigt wird, verbleibt der Zustandsautomat 4 im Zustand Z4. Wenn hingegen die Ladesäule die Abmeldung bestätigt hat, geht der Zustandsautomat 4 in den Zustand Z1 über, bei dem sich der Ladeassistent im Zustand <AUS> befindet.

Bei dem Zustandsautomat 4 werden somit Steuerdaten für das virtuelle Fahrzeugmodell 2 durch das virtuelle Funktionsmodell 1 erzeugt. Die technische Funktion des Ladens mittels des Ladeassistenten kann auf diese Weise simuliert werden, wobei technische Betriebszustände des Fahrzeugs erzeugt werden. Beim Erzeugen dieser technischen Betriebszustände des Fahrzeugs können vielfältige Elemente des Fahrzeugs des virtuellen Fahrzeugmodells 2 berücksichtigt werden.

Anschließend wird eine Gefahrenanalyse für verschiedene simulierte Betriebszustände des Fahrzeugs durchgeführt. Dabei werden insbesondere die bei der Simulation auftretenden Betriebszustände mit den vorab gespeicherten kritischen Betriebszuständen verglichen. Beispielsweise wird auf diese Weise geprüft, ob ein Abriss des Ladearms des Ladesäulenassistenten auftreten kann.

Das virtuelle Fahrzeugmodell 1 erfasst, wie vorstehend erläutert, Betriebszustände des simulierten Fahrzeugs. Hierzu zählt bei diesem Ausführungsbeispiel auch der Zustand der Feststellbremse. Bei der Simulation der Betriebszustände des Fahrzeugs wird daher der Fall berücksichtigt, dass beim Laden das durch das virtuelle Fahrzeugmodell 2 repräsentierte Fahrzeug eine nicht-aktivierte Feststellbremse aufweist.

Da das virtuelle Umgebungsmodell 3 die Topologie der Straße berücksichtigt, auf welcher das Fahrzeug des virtuellen Fahrzeugmodells 2 beim Laden steht, wird bei der Simulation der Fall berücksichtigt, dass der Stellplatz auf dieser Straße eine Neigung aufweist. In diesem Fall ergibt die Simulation der technischen Betriebszustände des Fahrzeugs den Fall, dass sich das Fahrzeug beim Laden in Bewegung setzt. Bei der Kopplung des virtuellen Funktionsmodells 1 mit dem virtuellen Fahrzeugmodell 2 ist berücksichtigt, dass der Ladearm zum Beispiel ein über einem Stecker mit dem Fahrzeug des virtuellen Fahrzeugmodells 2 gekoppelt ist. Die Simulation zeigt nun, dass der Ladearm abreißt, wenn sich das Fahrzeug des virtuellen Fahrzeugmodells 2 bewegt hat und eine bestimmte Strecke zurückgelegt hat. Bei der Gefahrenanalyse zeigt sich dann beispielsweise durch einen Zugriff auf eine Datenbank, dass dieser Abriss des Ladearms zu einer Gefährdung von Verkehrsteilnehmern in der Umgebung des Fahrzeugs führt. Entsprechende Situationen können vorab in einer Datenbank gespeichert sein, auf welche das virtuelle Funktionsmodell 1 zugreift. Aus dieser Gefahrenanalyse kann der Schluss gezogen werden, dass die fehlende Rückkopplung des Betriebszustands der Feststellbremse an den automatisierten Ladeassistenten zu der Gefährdung geführt hat. In dem virtuellen Funktionsmodell kann daher die folgende Anforderung ergänzt werden: "Falls der Ladeassistent im Zustand <VORBEREITEN> feststellt, dass das Fahrzeug steht und die Feststellbremse aktiv ist, soll es sich bei der Ladestation anmelden". Nach der Erstellung eines derart erweiterten virtuellen Funktionsmodells 1 kann das Verfahren erneut durchgeführt werden. In diesem Fall wird festgestellt, dass ein Abriss des Ladearms nicht möglich ist. Die Gefahrenanalyse fällt dann positiv aus.

Einem anderen Beispiel wird fortwährend geprüft, ob die bei der Simulation auftretenden Betriebszustände mit einem der gespeicherten kritischen Betriebszustände übereinstimmt. Falls eine solche Übereinstimmung festgestellt wurde, wird bei der Gefahrenanalyse eine Gefahrzustand festgestellt. Dieser kann dann ausgegeben werden.

Außerdem kann bei der Simulation erfasst werden, dass sich bestimmte Parameter des virtuellen Fahrzeugmodells 2 ändern können. Beispielsweise kann berücksichtigt werden, dass die Feststellbremse des Fahrzeugs während des Ladevorgangs gelöst wird. Diese Änderung des Parameters des virtuellen Fahrzeugmodells 2 führt bei der Simulation dazu, dass ein Betriebszustands auftreten kann, der einem der gespeicherten kritischen Betriebszustände entspricht. Bei der Gefahrenanalyse kann somit ausgegeben werden, dass die Feststellbremse nicht gelöst werden darf, wenn das Fahrzeug geladen wird und auf einer geneigten Fahrbahn abgestellt ist.

Es wird darauf hingewiesen, dass aufgrund der Komplexität der technischen Funktionen in Verbindung mit der Komplexität eines Fahrzeugs eine rein gedankliche Vorhersage des Verhaltens des Fahrzeugs bei der Implementierung der technischen Funktion nicht so umfassend möglich sein kann wie bei dem erfindungsgemäßen Verfahren. Die Simulation des erfindungsgemäßen Verfahrens kann Fehler und Schwächen sowie etwaige Gefährdungen und Sicherheitsprobleme frühzeitig offenbaren, und zwar noch bevor auch nur ein Prototyp für die technische Funktion geschaffen wurde. Hierdurch können Einsparungen und Zeitvorteile bei der Entwicklung der technischen Funktion geschaffen werden.

### Bezugszeichenliste

- 1: virtuelles Funktionsmodell
- 2: virtuelles Fahrzeugmodell
- 3: virtuelles Umgebungsmodell
- 4: Zustandsautomat

## Patentansprüche

1. Computerimplementiertes Verfahren zum Testen der Auswirkungen einer technischen Funktion auf ein Fahrzeug und/oder eine Fahrzeugumgebung, wobei
die technische Funktion durch ein virtuelles Funktionsmodell (1) beschrieben wird und
Betriebszustände des Fahrzeugs durch ein virtuelles Fahrzeugmodell (2) beschrieben werden,
wobei bei dem Verfahren eine Simulation der Implementierung der technischen Funktion in dem Fahrzeug durchgeführt wird, bei der die folgenden Schritte durchgeführt werden:
datentechnische Kopplung des virtuellen Funktionsmodells (1) mit dem virtuellen Fahrzeugmodell (2),
Erzeugen von Steuerdaten für das virtuelle Fahrzeugmodell (2) durch das virtuelle Funktionsmodell (1),
Simulieren von technischen Betriebszuständen des Fahrzeugs mittels des virtuellen Fahrzeugmodells (2) auf Basis der erzeugten Steuerdaten und
Durchführen einer Gefahrenanalyse für zumindest einen der simulierten Betriebszustände des Fahrzeugs,
**dadurch gekennzeichnet, dass**
für das virtuelle Fahrzeugmodell (2) kritische Betriebszustände definiert und gespeichert werden, nach dem Simulieren der technischen Betriebszustände des Fahrzeugs geprüft wird, ob diese technischen Betriebszustände mit einem der gespeicherten kritischen Betriebszuständen übereinstimmt, und, falls eine Übereinstimmung festgestellt wird, bei der Gefahrenanalyse ein Gefahrzustand festgestellt wird und der Gefahrzustand ausgegeben wird.

2. Verfahren nach Anspruch 1,
**dadurch gekennzeichnet, dass**
das virtuelle Funktionsmodell (1) ein technisches System voraussetzt, die Art der technischen Funktion angibt und einen Wichtigkeitsoperator zwischen dem vorausgesetzten technischen System und der Art der technischen Funktion umfasst.

3. Verfahren nach einem der vorhergehenden Ansprüche,
**dadurch gekennzeichnet, dass**
die datentechnische Kopplung des virtuellen Funktionsmodells (1) mit dem virtuellen Fahrzeugmodell (2) durch eine Transformation des virtuellen Funktionsmodells (1) und des virtuellen Fahrzeugmodells (2) in einen endlichen Zustandsautomaten (4) erfolgt.

4. Verfahren nach einem der vorhergehenden Ansprüche,
**dadurch gekennzeichnet, dass**
die Fahrzeugumgebung durch ein virtuelles Umgebungsmodell (3) beschrieben wird, das virtuelle Umgebungsmodell (3) datentechnisch mit dem virtuellen Fahrzeugmodell (2) und/oder dem virtuellen Fahrzeugmodell (2) gekoppelt wird und die technischen Betriebszuständen des Fahrzeugs mittels des virtuellen Fahrzeugmodells (2) und des virtuelles Umgebungsmodell (3) auf Basis der erzeugten Steuerdaten simuliert werden.

5. Verfahren nach einem der vorhergehenden Ansprüche,
**dadurch gekennzeichnet, dass**
bei der Gefahrenanalyse Gefährdungen durch simulierte technische Betriebszustände des Fahrzeugs berücksichtigt werden.

6. Verfahren nach einem der vorhergehenden Ansprüche,
**dadurch gekennzeichnet, dass**
bei der Gefahrenanalyse die Beherrschbarkeit einer Gefährdung durch einen Fahrer des Fahrzeugs oder durch andere am Straßenverkehr beteiligte Verkehrsteilnehmer berücksichtigt werden.

7. Verfahren nach einem der vorhergehenden Ansprüche,
**dadurch gekennzeichnet, dass**
bei der Gefahrenanalyse oder der Definition kritischer Betriebszustände gespeicherte Daten berücksichtigt werden, welche die Umwelt und das Fahrverhalten des durch das virtuelle Fahrzeugmodell (2) beschriebene Fahrzeug und/oder welche technische Betriebszustände bei Unfällen von Fahrzeugen beschreiben.

8. Verfahren nach einem der vorhergehenden Ansprüche,
**dadurch gekennzeichnet, dass**
das virtuelle Fahrzeugmodell bei der Simulation die erzeugten Steuerdaten in virtuelle fahrzeuginterne Signale umsetzt.

9. Verfahren nach Anspruch 8,
**dadurch gekennzeichnet, dass**
die virtuellen fahrzeuginternen Signale eine Bewegung des Fahrzeugs beschreiben.

10. Verfahren nach Anspruch 8 oder 9,
**dadurch gekennzeichnet, dass**
die virtuellen fahrzeuginternen Signale virtuelle Sensoren des Fahrzeugs und/oder einen virtuellen Antrieb des Fahrzeugs steuern.

11. System zum Testen der Auswirkungen einer technischen Funktion auf ein Fahrzeug und/oder eine Fahrzeugumgebung, mit
einer ersten Recheneinheit, die ausgelegt ist, die technische Funktion durch ein virtuelles Funktionsmodell (1) zu beschreiben,
einer zweiten Recheneinheit, die ausgelegt ist, Betriebszustände des Fahrzeugs durch ein virtuelles Fahrzeugmodell (2) zu beschreiben, und die datentechnisch mit der ersten Recheneinheit gekoppelt ist,
einer Simulationseinheit, die ausgelegt ist, eine Simulation der Implementierung der technischen Funktion in dem Fahrzeug durchzuführen, indem folgende Schritte durchgeführt werden:
Erzeugen von Steuerdaten für das virtuelle Fahrzeugmodell (2) der zweiten Recheneinheit durch das virtuelle Funktionsmodell (1) der ersten Recheneinheit,
Simulieren von technischen Betriebszuständen des Fahrzeugs mittels des virtuellen Fahrzeugmodells (2) der zweiten Recheneinheit auf Basis der erzeugten Steuerdaten,
Durchführen einer Gefahrenanalyse für zumindest einen der simulierten Betriebszustände des Fahrzeugs,
Definieren und Speichern von kritischen Betriebszuständen für das virtuelle Fahrzeugmodell (2),
Prüfen, ob diese technischen Betriebszustände mit einem der gespeicherten kritischen Betriebszuständen übereinstimmt, und, falls eine Übereinstimmung festgestellt wird, bei der Gefahrenanalyse ein Gefahrzustand festgestellt wird und der Gefahrzustand ausgegeben wird.

12. System nach Anspruch 11,
**dadurch gekennzeichnet, dass**
die Simulationseinheit einen Speicher umfasst, in welchem vorab definierte kritische Betriebszustände für das virtuelle Fahrzeugmodell (2) gespeichert sind und die Simulationseinheit ausgebildet ist, nach dem Simulieren der technischen Betriebszustände des Fahrzeugs zu prüfen, ob diese technischen Betriebszustände mit einem der gespeicherten kritischen Betriebszustände übereinstimmt, und, falls eine Übereinstimmung festgestellt wird, bei der Gefahrenanalyse eine Gefahrzustand festzustellen.

13. Computerlesbares Speichermedium, umfassend Befehle, die bei der Ausführung durch einen Computer diesen veranlassen, das Verfahren nach einem der Ansprüche 1 bis 10 auszuführen.

## Claims

1. Computer-implemented method for testing the effects of a technical function on a vehicle and/or vehicle surroundings, wherein
the technical function is described by a virtual function model (1) and
operating states of the vehicle are described by a virtual vehicle model (2),
wherein the method involves carrying out a simulation of the implementation of the technical function in the vehicle, which involves carrying out the following steps:
coupling the virtual function model (1) to the virtual vehicle model (2) for data transfer purposes,
generating control data for the virtual vehicle model (2) by way of the virtual function model (1),
simulating technical operating states of the vehicle by means of the virtual vehicle model (2) on the basis of the generated control data, and
carrying out a risk assessment for at least one of the simulated operating states of the vehicle,
**characterized in that**
critical operating states are defined and stored for the virtual vehicle model (2), the simulation of the technical operating states of the vehicle is followed by checking being performed to ascertain whether these technical operating states match one of the stored critical operating states, and, if a match is found, a hazardous state is identified during the risk assessment and the hazardous state is output.

2. Method according to Claim 1,
**characterized in that**
the virtual function model (1) presupposes a technical system that specifies the type of technical function and comprises an importance operator between the presupposed technical system and the type of technical function.

3. Method according to either of the preceding claims, **characterized in that**
the virtual function model (1) is coupled to the virtual vehicle model (2) for data transfer purposes by transforming the virtual functional model (1) and the virtual vehicle model (2) into a finite state machine (4) .

4. Method according to one of the preceding claims, **characterized in that**
the vehicle surroundings are described by a virtual surroundings model (3), the virtual surroundings model (3) is coupled to the virtual vehicle model (2) and/or the virtual vehicle model (2) for data transfer purposes, and the technical operating states of the vehicle are simulated by means of the virtual vehicle model (2) and the virtual surroundings model (3) on the basis of the generated control data.

5. Method according to one of the preceding claims, **characterized in that**
the risk assessment takes account of threats from simulated technical operating states of the vehicle.

6. Method according to one of the preceding claims, **characterized in that**
the risk assessment takes account of the manageability of a threat by a driver of the vehicle or by other road users participating in the road traffic.

7. Method according to one of the preceding claims, **characterized in that**
the risk assessment or the definition of critical operating states takes account of stored data that describe the environment and the driving behaviour of the vehicle described by the virtual vehicle model (2) and/or that describe technical operating states in the event of accidents involving vehicles.

8. Method according to one of the preceding claims, **characterized in that**
the virtual vehicle model converts the generated control data into virtual vehicle-internal signals during the simulation.

9. Method according to Claim 8,
**characterized in that**
the virtual vehicle-internal signals describe a motion of the vehicle.

10. Method according to Claim 8 or 9,
**characterized in that**
the virtual vehicle-internal signals control virtual sensors of the vehicle and/or a virtual drive of the vehicle.

11. System for testing the effects of a technical function on a vehicle and/or vehicle surroundings, having a first computing unit, which is designed to describe the technical function by way of a virtual function model (1),
a second computing unit, which is designed to describe operating states of the vehicle by way of a virtual vehicle model (2), and which is coupled to the first computing unit for data transfer purposes,
a simulation unit, which is designed to carry out a simulation of the implementation of the technical function in the vehicle by carrying out the following steps:
generating control data for the virtual vehicle model (2) of the second computing unit by way of the virtual function model (1) of the first computing unit,
simulating technical operating states of the vehicle by means of the virtual vehicle model (2) of the second computing unit on the basis of the generated control data,
carrying out a risk assessment for at least one of the simulated operating states of the vehicle,
defining and storing critical operating states for the virtual vehicle model (2),
checking whether these technical operating states match one of the stored critical operating states, and, if a match is found, identifying a hazardous state during the risk assessment and outputting the hazardous state.

12. System according to Claim 11,
**characterized in that**
the simulation unit comprises a memory that stores previously defined critical operating states for the virtual vehicle model (2), and the simulation unit is designed so as, following the simulation of the technical operating states of the vehicle, to check whether these technical operating states match one of the stored critical operating states, and, if a match is found, to identify a hazardous state during the risk assessment.

13. Computer-readable storage medium, comprising commands that, when executed by a computer, cause said computer to carry out the method according to one of Claims 1 to 10.

## Revendications

1. Procédé mis en œuvre par ordinateur destiné aux essais des effets d'une fonction technique sur un véhicule et/ou sur un environnement de véhicule, dans lequel
la fonction technique est décrite par un modèle de fonction virtuel (1) et
des états de fonctionnement du véhicule sont décrits par un modèle de véhicule virtuel (2),
dans lequel la procédé consiste à effectuer une simulation de la mise en œuvre de la fonction technique dans le véhicule, lors de laquelle on exécute les étapes suivantes, consistant à :
coupler de manière informatique le modèle de fonction virtuel (1) avec le modèle de véhicule virtuel (2),
générer des données de commande pour le modèle de véhicule virtuel (2) à l'aide du modèle de fonction virtuel (1),
simuler des états de fonctionnement techniques du véhicule au moyen du modèle de véhicule virtuel (2) sur la base des données de commande générées, et
réaliser une analyse de risques pour au moins l'un des états de fonctionnement simulés du véhicule,
**caractérisé en ce que**,
pour le modèle de véhicule virtuel (2), des états de fonctionnement critiques sont définis et mémorisés, après la simulation des états de fonctionnement techniques du véhicule, il est vérifié si ces états de fonctionnement techniques correspondent à l'un des états de fonctionnement critiques mémorisés, et si une correspondance est constatée, lors de l'analyse de risques, un état de risque est constaté et l'état de risque est délivré en sortie.

2. Procédé selon la revendication 1, **caractérisée en ce que**
le modèle de fonction virtuel (1) présuppose un système technique, indique le type de la fonction technique et comprend un opérateur d'importance entre le système technique présupposé et le type de la fonction technique.

3. Procédé selon l'une des revendications précédentes, **caractérisé en ce que**
le couplage informatique du modèle de fonction virtuel (1) avec le modèle de véhicule virtuel (2) s'effectue par une transformation du modèle de fonction virtuel (1) et du modèle de véhicule virtuel (2) dans un automate à états finis (4).

4. Procédé selon l'une des revendications précédentes, **caractérisé en ce que**
l'environnement du véhicule est décrit par un modèle d'environnement virtuel (3), le modèle d'environnement virtuel (3) est couplé de manière informatique au modèle de véhicule virtuel (2) et/ou au modèle de véhicule virtuel (2) et les états de fonctionnement techniques du véhicule sont simulés au moyen du modèle de véhicule virtuel (2) et du modèle d'environnement virtuel (3) sur la base des données de commande générées.

5. Procédé selon l'une des revendications précédentes, **caractérisé en ce que**,
lors de l'analyse de risques, les risques sont pris en compte par les états de fonctionnement techniques simulés du véhicule.

6. Procédé selon l'une des revendications précédentes, **caractérisé en ce que**,
lors de l'analyse de risques, la possibilité de maîtrise d'un risque par un conducteur du véhicule ou par d'autres usagers de la route impliqués dans la circulation sont pris en compte.

7. Procédé selon l'une des revendications précédentes, **caractérisé en ce que**,
lors de l'analyse de risques ou de la définition d'états de fonctionnement critiques, il est tenu compte des données mémorisées qui décrivent l'environnement et le comportement de conduite du véhicule décrit par le modèle de véhicule virtuel (2) et/ou qui décrivent des états de fonctionnement techniques en cas d'accidents de véhicules.

8. Procédé selon l'une des revendications précédentes, **caractérisé en ce que**
le modèle de véhicule virtuel, lors de la simulation, convertit les données de commande générées en signaux virtuels internes au véhicule.

9. Procédé selon la revendication 8, **caractérisé en ce que**
les signaux virtuels internes au véhicule décrivent un mouvement du véhicule.

10. Procédé selon la revendication 8 ou 9, **caractérisé en ce que**
les signaux virtuels internes au véhicule commandent des capteurs virtuels du véhicule et/ou une propulsion virtuelle du véhicule.

11. Système destiné aux essais des effets d'une fonction technique sur un véhicule et/ou sur un environnement de véhicule, comprenant
une première unité de calcul qui est conçue pour décrire la fonction technique par un modèle de fonction virtuel (1),
une deuxième unité de calcul qui est conçue pour décrire des états de fonctionnement du véhicule par un modèle de véhicule virtuel (2) et qui est couplée de manière informatique à la première unité de calcul,
une unité de simulation qui est conçue pour effectuer une simulation de la mise en œuvre de la fonction technique dans le véhicule, par exécution des étapes suivantes consistant à :
générer des données de commande pour le modèle de véhicule virtuel (2) de la deuxième unité de calcul à l'aide du modèle de fonction virtuel (1) de la première unité de calcul,
simuler des états de fonctionnement techniques du véhicule au moyen du modèle de véhicule virtuel (2) de la deuxième unité de calcul sur la base des données de commande générées,
réaliser une analyse de risques pour au moins l'un des états de fonctionnement simulés du véhicule,
définir et mémoriser des états de fonctionnement critiques pour le modèle de véhicule virtuel (2),
vérifier si ces états de fonctionnement techniques correspondent à l'un des états de fonctionnement critiques mémorisés et, si une correspondance est constatée, lors de l'analyse de risques, un état de risque est constaté et l'état de risque est délivré en sortie.

12. Système selon la revendication 11, **caractérisé en ce que**
l'unité de simulation comprend une mémoire dans laquelle sont mémorisés des états de fonctionnement critiques prédéfinis pour le modèle de véhicule virtuel (2) et l'unité de simulation est conçue pour vérifier, après la simulation des états de fonctionnement techniques du véhicule, si ces états de fonctionnement techniques correspondent à l'un des états de fonctionnement critiques mémorisés et, si une correspondance est constatée, pour constater un état de risque lors de l'analyse de risques.

13. Support de stockage lisible par ordinateur comprenant des instructions qui, lors de leur exécution par un ordinateur, amènent ce dernier à mettre en œuvre le procédé selon l'une des revendications 1 à 10.
